# EUROPEAN PATENT APPLICATION

(11) **EP 3 978 145 A1**
(43) Date of publication of application: **06.04.2022**
(21) Application number: 20814784.3
(22) Date of filing: 28.05.2020
(51) Int. Cl.: B05D 1/38, B05D 3/00, B05D 3/02, B05D 5/12, C01G 25/00, H01L 41/113, H01L 41/187, H01L 41/317, H01L 41/318, H01L 41/319, C04B 35/491

(54) **METHOD FOR MANUFACTURING PIEZOELECTRIC FILM, PIEZOELECTRIC FILM, AND PIEZOELECTRIC ELEMENT**

(30) Priority: 31.05.2019 JP 2019102452; 31.05.2019 JP 2019102536; 30.03.2020 JP 2020059572
(71) Applicant: Mitsubishi Materials Corporation, Tokyo 100-8117 (JP)
(72) Inventor: DOI, Toshihiro, Naka-shi, Ibaraki 311-0102 (JP); SOYAMA, Nobuyuki, Naka-shi, Ibaraki 311-0102 (JP)
(74) Representative: Gille Hrabal Partnerschaftsgesellschaft mbB Patentanwälte
(86) International application number: PCT/JP2020/021091
(87) International publication number: WO 2020/241743

(57) **Abstract**

This method for manufacturing a piezoelectric film includes: a coating step of obtaining a coated film by coating a coating solution on a substrate, wherein the coating solution includes at least lead, zirconium, and titanium, a content ratio of the zirconium and the titanium is in a range of 54:46 to 40:60 in terms of molar ratio, and a perovskite crystal phase is generated by heating the coating solution at a temperature equal to or higher than a crystallization initiation temperature; a drying step of obtaining a dried film by drying the coated film; a first calcining step of obtaining a first calcined film by heating the dried film at a first calcining temperature in a range of equal to or higher than the crystallization initiation temperature and equal to or lower than a temperature of the crystallization initiation temperature + 40°C; a second calcining step of obtaining a second calcined film by heating the first calcined film at a second calcining temperature which is equal to or higher than a temperature of the first calcining temperature + 25°C and in a range of equal to or higher than a temperature of the crystallization initiation temperature + 25°C and equal to or lower than a temperature of the crystallization initiation temperature + 100°C; and a main firing step of obtaining a piezoelectric film by heating the second calcined film at a main firing temperature which is equal to or higher than a temperature of the second calcining temperature + 25°C and in a range of equal to or higher than a temperature of the crystallization initiation temperature + 100°C and equal to or lower than a temperature of the crystallization initiation temperature + 200°C.

## Description

### TECHNICAL FIELD

The present invention relates to a method for manufacturing a piezoelectric film, a piezoelectric film, and a piezoelectric element.

The present application claims priority on Japanese Patent Application No. 2019-102452 filed on May 31, 2019, Japanese Patent Application No. 2019-102536 filed on May 31, 2019, and Japanese Patent Application No. 2020-059572 filed on March 30, 2020, the contents of which are incorporated herein by reference.

### BACKGROUND ART

A piezoelectric element including a piezoelectric film and electrodes formed on the top and bottom surfaces of the piezoelectric film is used in various piezoelectric devices, such as vibration-generating elements, sensors, actuators, ink jet heads, and auto-focusing devices. As materials for the piezoelectric film, PZT-based piezoelectric materials having a perovskite crystal phase including lead (Pb), zirconium (Zr), and titanium (Ti) are widely used. Chemical solution deposition methods (CSD method; also known as sol-gel method) and sputtering methods are known as methods for manufacturing PZT-based piezoelectric films.

In the CSD method, a precursor solution (or sol-gel solution) including metallic elements of the targeted composition is coated on the surface of a substrate and the obtained coated film is fired to manufacture a piezoelectric film. In the sputtering method, the oxide target is bombarded with, for example, ionized argon or the like in a high vacuum and elements ejected thereby are deposited on the substrate to manufacture the piezoelectric film. In comparison with the sputtering method, the CSD method is advantageous in that a high vacuum is not necessary and it is possible to manufacture piezoelectric films using a relatively small apparatus.

In general, piezoelectric films obtained by the sputtering method are a single phase formed of a tetragonal perovskite crystal structure grown in a columnar shape and tend to have a high composition uniformity (Non-Patent Document 1). On the other hand, in general, piezoelectric films obtained by the CSD method do not tend to easily grow in a columnar shape, and the piezoelectric films obtained by the CSD method tend to have a plurality of phases such as tetragonal perovskite crystal structures, cubic-type perovskite crystal structures, and orthorhombic-type perovskite crystal structures mixed therein, and tend to be provided with a concentration gradient in the thickness direction (Non-Patent Document 2).

Non-Patent Document 2 describes the method below as a method for manufacturing a PZT-based piezoelectric film with a gentle Zr/Ti composition gradient in the film thickness direction. A plurality of coating solutions with different Zr/Ti compositions are coated and the obtained laminate body of the plurality of coated films is fired to manufacture a piezoelectric film. In the upper part of the laminate body, a coating solution with a relatively high Ti content is coated to form a coated film, and in the lower part of the laminate body, a coating solution with a relatively high Zr content is coated to form a coated film.

In addition, Patent Document 1 describes the method below as a method for manufacturing a PZT-based piezoelectric film with a gentle Zr/Ti composition gradient in the film thickness direction using one type of coating solution. The formation of a coated film, calcining using a hot plate or the like at a temperature of 275°C to 325°C, and an intermediate heat treatment at a temperature of 525°C to 550°C are repeated a plurality of times. Next, firing is carried out at a temperature of 650°C to 750°C. The formation of the coated film, the calcining, the intermediate heat treatment, and the firing described above are repeated a plurality of times.

In the method described in Non-Patent Document 2, a plurality of coating solutions with different compositions are coated and the obtained laminate body of coated film s is fired to manufacture a piezoelectric film. In this method, tanks for storing each of various coating solutions with different compositions and an apparatus for coating those coating solutions in order are necessary, thus, there is a concern that the equipment cost may be high and the management cost thereof may also be high.

On the other hand, in the method described in Patent Document 1, the formation of the coated film, the calcining using a hot plate or the like, and the intermediate heat treatment are repeated, and then firing is conducted. These steps of the formation of the coated film, the calcining, the intermediate heat treatment, and the firing are repeated a plurality of times. This method is advantageous in that it is not necessary to change the composition of the coating solution. However, according to an examination of this method by the inventors of the present invention, it was determined that, depending on the conditions of the treatment temperature of the intermediate heat treatment and the firing temperature, peeling and cracking may be generated in the obtained piezoelectric film and the yield may be low.

In addition, piezoelectric films used in piezoelectric elements for sensors preferably have a high piezoelectric property to improve sensitivity and a high voltage endurance property to increase reliability.

The piezoelectric film obtained by the sputtering method is a single phase consisting of a tetragonal perovskite crystal structure and thus has a high piezoelectric property, but has a low voltage endurance property due to the high composition uniformity thereof. On the other hand, the piezoelectric film obtained by the CSD method has a high voltage endurance property due to a concentration gradient in the thickness direction, but there is a problem in that the piezoelectric property is low due to the difficulty in growing perovskite crystals in a columnar shape.

### PRIOR ART DOCUMENTS

### Patent Document

Patent Document 1: Japanese Unexamined Patent Application, First Publication No. 2018-148113

### Non-Patent Documents

Non-Patent Document 1: Journal of Applied Physics 116, 194102 (2014)
Non-Patent Document 2: Applied Physics Letters Vol. 90, 2007, 062907 to 062907-3

### DISCLOSURE OF INVENTION

### Problems to be Solved by the Invention

In consideration of the circumstances described above, the present invention has an object of providing a method which is able to manufacture a piezoelectric film having a high composition uniformity in the thickness direction with a high yield and without using coating solutions having different compositions. In addition, another object of the present invention is to provide a piezoelectric film and a piezoelectric element having a high piezoelectric property and voltage endurance property.

### Solutions for Solving the Problems

In order to solve the above problem, a method for manufacturing a piezoelectric film according to one aspect of the present invention includes a coating step of obtaining a coated film by coating a coating solution on a substrate, wherein the coating solution includes at least lead, zirconium, and titanium, a content ratio of the zirconium and the titanium is in a range of 54:46 to 40:60 in terms of molar ratio, and a perovskite crystal phase is generated by heating the coating solution at a temperature equal to or higher than a crystallization initiation temperature; a drying step of obtaining a dried film by drying the coated film; a first calcining step of obtaining a first calcined film by heating the dried film at a first calcining temperature in a range of equal to or higher than the crystallization initiation temperature and equal to or lower than a temperature of the crystallization initiation temperature + 40°C; a second calcining step of obtaining a second calcined film by heating the first calcined film at a second calcining temperature which is equal to or higher than a temperature of the first calcining temperature + 25°C and in a range of equal to or higher than a temperature of the crystallization initiation temperature + 25°C and equal to or lower than a temperature of the crystallization initiation temperature + 100°C; and a main firing step of obtaining a piezoelectric film by heating the second calcined film at a main firing temperature which is equal to or higher than a temperature of the second calcining temperature + 25°C and in a range of equal to or higher than a temperature of the crystallization initiation temperature + 100°C and equal to or lower than a temperature of the crystallization initiation temperature + 200°C.

According to the method for manufacturing a piezoelectric film with this configuration, since the content ratio of the zirconium and the titanium in the coating solution is in a range of 54:46 to 40:60 in terms of molar ratio, it is possible to obtain a piezoelectric film having a high piezoelectric property and voltage endurance property. In addition, since the first calcining temperature in the first calcining step is a relatively low temperature in a range of the crystallization initiation temperature or higher and equal to or lower than a temperature of the crystallization initiation temperature + 40°C, variation does not easily occur in the temperature in the film thickness direction and crystallization proceeds uniformly, thus, the compositional gradient of Zr/Ti in the film thickness direction becomes gentle. Furthermore, since a perovskite crystal phase is partially generated in the first calcined film obtained in the first calcining step, subsequent heating does not easily increase the compositional gradient of Zr/Ti in the film thickness direction. Moreover, by performing the second calcining step after the first calcining step and before the main firing step, the amount of change in the film structure due to crystallization of the film caused by the heating in the main firing step becomes small and the stress generated in the film becomes small. For this reason, peeling and cracking do not easily occur in the obtained piezoelectric film. Thus, by using the method for manufacturing a piezoelectric film having the configuration described above, it is possible to manufacture piezoelectric films having a high composition uniformity in the thickness direction with a high yield and without using coating solutions having different compositions.

In the method for manufacturing a piezoelectric film according to one aspect of the present invention, the coating step, the drying step, and the first calcining step are preferably repeatedly performed before the second calcining step.

In such a case, it is possible to easily adjust the film thickness of the obtained piezoelectric film according to the number of repetitions of the coating step, the drying step, and the first calcining step.

In addition, in the method for manufacturing a piezoelectric film according to one aspect of the present invention, the coating solution preferably contains an organic substance, and the method preferably further includes an organic substance removing step of removing the organic substance included in the dried film by heating the dried film after the drying step and before the first calcining step.

In such a case, in the first calcining step, the generation of peeling or cracking in the first calcined film due to rapid evaporation of the organic substance is suppressed, thus, it is possible to manufacture the piezoelectric film more reliably at a high yield.

In a method for manufacturing a piezoelectric film according to one aspect of the present invention, a content ratio of the zirconium and the titanium in the coating solution is preferably in a range of 50:50 to 40:60 in terms of molar ratio.

In such a case, the piezoelectric property of the piezoelectric film to be manufactured is greatly improved.

A piezoelectric film according to one aspect of the present invention includes a tetragonal perovskite crystal including at least lead, zirconium, and titanium, in which the tetragonal perovskite crystal has a ratio of a length of a c-axis to a length of an a-axis in a range of 1.0071 or more and 1.0204 or less, and, when a linear analysis of concentrations of zirconia and titanium in a thickness direction is carried out, a difference between a lowest value and a highest value of a molar ratio of the concentration of titanium to the concentration of zirconia is more than 0.1 and 0.45 or less.

According to the piezoelectric film with this configuration, the tetragonal perovskite crystal has a ratio of the length of the c-axis with respect to the length of the a-axis in a range of 1.0071 or more and 1.0204 or less, thus, the piezoelectric property is improved. In addition, when a linear analysis of the concentrations of zirconia and titanium in the thickness direction is carried out, the difference between the lowest value and the highest value of the ratio of the concentration of titanium to the concentration of zirconia is more than 0.1 and 0.45 or less and a slight concentration gradient is provided in the thickness direction, thus, the voltage endurance property is improved.

In the piezoelectric film according to one aspect of the present invention, in an X-ray diffraction pattern measured using a Cu-Ka line, a half width of a diffraction peak derived from a (400) plane of the tetragonal perovskite crystal is preferably 1.40 degrees or less in terms of a diffraction angle of 2θ.

In such a case, since the half width of the diffraction peak derived from the (400) plane of the tetragonal perovskite crystal is 1.40 degrees or less in terms of a diffraction angle of 2θ, the variation in the orientation direction of the tetragonal perovskite crystal is reduced and the piezoelectric property of the piezoelectric film is further improved.

In addition, in the piezoelectric film according to one aspect of the present invention, the film thickness is preferably in a range of 0.5 µm or more and 5 µm or less.

In such a case, it is possible to reliably form a gradient of zirconia concentration and titanium concentration in the thickness direction of the piezoelectric film.

A piezoelectric element according to one aspect of the present invention includes a piezoelectric layer, and an electrode layer formed on a surface of the piezoelectric layer, in which the piezoelectric layer includes the piezoelectric film of the present invention described above.

According to the piezoelectric element with this configuration, since the piezoelectric layer includes the piezoelectric film according to the one aspect of the present invention described above, the piezoelectric property and the voltage endurance property are improved.

### Effects of Invention

According to one aspect of the present invention, it is possible to manufacture a piezoelectric film with a high composition uniformity in the thickness direction with a high yield and without using coating solutions with different compositions. In addition, according to one aspect of the present invention, it is possible to provide a piezoelectric film and a piezoelectric element which have a high piezoelectric property and a high voltage endurance property.

### BRIEF DESCRIPTION OF DRAWINGS

FIG. 1 is a flow diagram of a method for manufacturing a piezoelectric film according to one embodiment of the present invention.
FIG. 2 is a schematic cross-sectional view of a piezoelectric element using a piezoelectric film according to one embodiment of the present invention.

### EMBODIMENTS FOR CARRYING OUT THE INVENTION

A description will be given below of a method for manufacturing a piezoelectric film according to one embodiment of the present invention with reference to the accompanying drawings. In the description below, a case of manufacturing a PZT-based piezoelectric film as the piezoelectric film will be described as an example. Examples of PZT-based piezoelectric films include a PZT (lead zirconate titanate) piezoelectric film, a PNbZT (niobium-doped lead zirconate titanate) piezoelectric film, a PLZT (lanthanum-doped lead zirconate titanate) piezoelectric film, and the like.

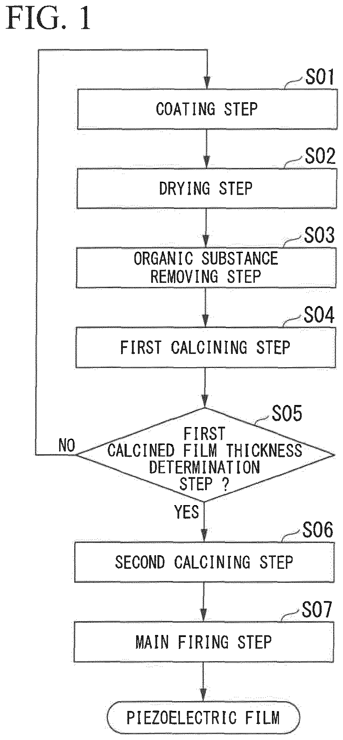

FIG. 1 is a flow diagram of a method for manufacturing a piezoelectric film according to one embodiment of the present invention.

The method for manufacturing a piezoelectric film shown in FIG. 1 includes a coating step S01, a drying step S02, an organic substance removing step S03, a first calcining step S04, a first calcined film thickness determination step S05, a second calcining step S06, and a main firing step S07.

### (Coating Step S01)

The coating step S01 is a step of obtaining a coated film by coating a coating solution on a substrate.

As a substrate, it is possible to use a heat-resistant substrate with a lower electrode formed on the surface thereof.

As the heat-resistant substrate, it is possible to use a silicon substrate, a stainless steel substrate, an alumina substrate, and the like. In a case where a silicon substrate is used, it is desirable to form a thermally oxidized film (SiOₓ film) on the surface of the silicon substrate by thermally oxidizing the surface of the silicon substrate in order to suppress the diffusion of the constituent elements (in particular, lead) of the PZT-based piezoelectric film. The heat-resistant substrate may further include an adhesion layer in order to improve the adhesion with the lower electrode. It is possible to use a titanium film or a titanium oxide film (TiOₓ film) as the adhesion layer. It is possible to deposit the titanium film by, for example, a sputtering method. On the other hand, it is possible to deposit the titanium oxide film by holding and firing a titanium film at a temperature of 700°C to 800°C for 1 to 3 minutes in an air atmosphere.

It is possible to use Pt as the material for the lower electrode. The Pt lower electrode is preferably oriented in the (111) direction. It is possible to form the Pt lower electrode oriented in the (111) direction by the sputtering method. In addition, in order to improve the adhesion between the lower electrode and the PZT-based piezoelectric film, a base layer may be provided on the surface of the lower electrode. It is possible to use a lanthanum nickelate film as the base layer. It is possible to deposit the lanthanum nickelate film, for example, by a method of coating a sol-gel solution, which generates a lanthanum nickelate film by heating, on the surface of the lower electrode and then carrying out heating (sol-gel method). In addition, as described below, an adhesion layer may be provided on the surface of the base layer. It is possible to use lead titanate as the adhesion layer.

Accordingly, on the surface (top surface) of the heat-resistant substrate, a thermally oxidized film (in a case where the heat-resistant substrate is a silicon substrate), an adhesion layer, a lower electrode (Pt lower electrode), a base layer, and an adhesion layer may be formed in this order from bottom to top.

The coating solution includes at least lead, zirconium, and titanium. The coating solution may include elements which produce a PZT-based piezoelectric material, together with the lead, zirconium, and titanium. Examples of the added elements include lanthanum and niobium.

The coating solution includes lead, zirconium, titanium, and the added elements in a ratio which produces a perovskite crystal phase by being heated at a temperature which is the crystallization initiation temperature or higher. The crystallization initiation temperature is the temperature at which oxides having crystallinity are produced when heating the coating solution.

The crystallization initiation temperature is measured by the following method. The coating solution is coated on the surface of the substrate described above to obtain a coated film. The coated film is dried in accordance with the drying step S02 described below to obtain a dried film. Next, the dried film is heated in accordance with the organic substance removing step S03 described below to remove an organic substance included in the dried film. Next, the dried film is fired at 450°C in an air atmosphere to produce a fired film. By the same operation, the dried film is fired at each temperature from 450°C to 600°C in 5°C increments to produce a fired film. The X-ray diffraction patterns of the produced fired films are measured by a concentration method using the CuKα line. In the obtained X-ray diffraction pattern, it is confirmed whether there is a peak derived from the (100) plane of the PZT film (diffraction peak derived from the (100) plane of the tetragonal perovskite crystal) at around 22 degrees of a diffraction angle of 2θ.For a fired film for which this peak is confirmed, the lowest firing temperature at which the fired film is produced is set as the crystallization initiation temperature. The conditions of the above-described step of obtaining a coated film, step of obtaining a dried film, step of removing an organic substance, and firing time are preferably the same as the conditions for manufacturing the piezoelectric film. A description will be given below of the specific method for measuring the crystallization initiation temperature in the

### Examples described below.

The coating solution has a content ratio of zirconium and titanium in a range of zirconium:titanium = 54:46 to 40:60 in terms of molar ratio. By setting the content ratio of zirconium and titanium in this range, it is possible to obtain piezoelectric films with an improved piezoelectric property and voltage endurance property. The content ratio of zirconium and titanium is preferably in a range of zirconium:titanium = 50:50 to 40:60 in terms of molar ratio. By setting the content ratio of zirconium and titanium in this range, it is possible to obtain a piezoelectric film including a tetragonal perovskite crystal in which the ratio of the length of the c-axis with respect to the length of the a-axis is in a range of 1.0071 or more and 1.0204 or less and in which the piezoelectric property is further improved.

The coating solution is preferably a sol-gel solution including the metals described above. For example, it is possible to prepare the sol-gel solution as follows. First, Zr tetra-n-butoxide (Zr source), Ti isopropoxide (Ti source), and acetylacetone (stabilizer) are placed in a reaction container and a mixture is refluxed in a nitrogen atmosphere. Next, lead acetate trihydrate (Pb source) is added to the reaction container, propylene glycol (solvent) is also added, and refluxing is carried out in a nitrogen atmosphere to obtain a sol-gel solution of lead zirconate titanate. Next, the obtained sol-gel solution is distilled under reduced pressure to remove by-products, then propylene glycol and alcohol are further added to adjust the concentration. In addition, as a coating solution for forming a PZT-based piezoelectric film (coating solution for forming (producing) a PZT-based piezoelectric film), it is possible to use a PZT-N solution sold by Mitsubishi Materials Corporation.

The coating solution is coated on an electrode of the substrate, a base film (base layer), or an adhesion layer which is formed on a surface of the electrode. Due to this, a coated film is obtained. The method for coating the coating solution is not particularly limited and it is possible to use the spin coating method, the dip coating method, the ink jet method, and the like.

### (Drying Step S02)

The drying step S02 is a step of obtaining a dried film by drying the coated film obtained in the coating step S01. The method for drying the coated film is not particularly limited and it is possible to use a heating and drying method, a reduced-pressure drying method, a ventilation drying method, and the like. In a case of using the heating and drying method, the heating temperature is preferably the temperature at which the solvent of the coating solution volatilizes or higher and a temperature at which the organic components of the metal source included in the coating solution do not decompose and evaporate. The heating time varies depending on the film thickness of the coated film, the solvent content, and the like, but is preferably in a range of 30 seconds or more and 5 minutes or less. The heating atmosphere is not particularly limited, but an air atmosphere is preferable. As a heating apparatus, it is possible to use a hot plate or an infrared rapid thermal annealing apparatus (RTA). Hot plates are preferable as the heating apparatus.

### (Organic Substance Removing Step S03)

The organic substance removing step S03 is a step to remove an organic substance included in the dried film by heating. That is, in the organic substance removing step S03, the organic components of the metal source included in the dried film are removed. Due to this, rapid decomposition and evaporation of the organic substance by heating in the following first calcining step S04 is suppressed. The heating temperature is preferably the temperature at which the organic components decompose and volatilize or higher and a temperature at which metal oxides (for example, lead titanate) are not formed. The heating time varies depending on the film thickness of the dried film, the content of organic components, and the like, but is preferably in a range of 30 seconds or more and 5 minutes or less. The heating atmosphere is not particularly limited, but an air atmosphere is preferable. As a heating apparatus, it is possible to use a hot plate or an infrared rapid thermal annealing apparatus (RTA). It is preferable to continuously perform the drying step S02 and the organic substance removing step S03 using a hot plate as the heating apparatus.

### (First Calcining Step S04)

The first calcining step S04 is a step of obtaining a first calcined film by heating a dried film from which an organic substance is removed by the organic substance removing step S03 at a first calcining temperature in a range of equal to or higher than a crystallization initiation temperature and the temperature of (crystallization initiation temperature + 40°C) or lower. For example, in a case where the crystallization initiation temperature is 550°C, the first calcining temperature is 550°C or higher and 590°C or lower. In the first calcining step S04, the first calcining temperature is in the range described above and a part of the dried film crystallizes but the majority thereof does not crystallize, thus, it is difficult for the compositional gradient of Zr/Ti in the film thickness direction to occur. In addition, the obtained first calcined film includes a partially formed perovskite crystal phase, thus, the residual stress is greatly reduced and thick lamination is possible. From the above-described two points, it is possible to greatly reduce the compositional gradient of Zr/Ti in the final product.

In the first calcining step S04, the heating time varies depending on the thickness, size, and the like of the dried film, but is preferably in a range of 30 seconds or more and 5 minutes or less. The heating atmosphere is not particularly limited, but an air atmosphere is preferable. As a heating apparatus, it is possible to use a hot plate or a rapid thermal annealing apparatus (RTA). It is preferable to continuously perform the organic substance removing step S03 and the first calcining step S04 using a hot plate as the heating apparatus.

### (First Calcined Film Thickness Determination Step S05)

The first calcined film thickness determination step S05 is a step of measuring the film thickness of the first calcined film obtained in the first calcining step S04 and determining whether or not the film thickness of the first calcined film is the desired film thickness. In a case where the film thickness of the first calcined film is thinner than the desired film thickness (the case of NO in FIG. 1), the coating step S01, the drying step S02, the organic substance removing step S03, and the first calcining step S04 are repeatedly performed. In addition, in a case where the film thickness of the first calcined film is thicker than the desired film thickness, the coating amount of the coating solution in the coating step S01 is adjusted. In a case where the film thickness of the first calcined film is the desired film thickness (the case of YES in FIG. 1), the second calcining step S06 is performed next. It is possible to measure the film thickness of the first calcined film by using, for example, a spectral interference film thickness measuring apparatus.

### (Second Calcining Step S06)

The second calcining step S06 is a step for obtaining a second calcined film by heating the first calcined film having a desired film thickness at a second calcining temperature which is in a range of equal to or higher than a temperature of (crystallization initiation temperature + 25°C) and equal to or lower than a temperature of (crystallization initiation temperature + 100°C) and which is equal to or higher than a temperature of (first calcining temperature + 25°C). For example, in a case where the crystallization initiation temperature is 550°C, the second calcining temperature is 575°C or higher and 650°C or lower and is the temperature of (first calcining temperature +25°C) or higher. In the second calcining step S06, since the second calcining temperature is in the range described above, a second calcined film with more advanced crystallization than the first calcined film is generated. In the second calcined film, in the X-ray diffraction pattern measured using the CuKα line, the intensity of the peak derived from the (100) plane of the PZT-based piezoelectric material (diffraction peak derived from the (100) plane of the tetragonal perovskite crystal), which is confirmed at around 22 degrees of a diffraction angle of 2θ, is preferably 10 or more times higher than that of the first calcined film. That is, the intensity of the peak derived from the (100) plane of the PZT-based piezoelectric material in the X-ray diffraction pattern of the second calcined film is preferably 10 or more times higher than the intensity of the peak derived from the (100) plane of the PZT-based piezoelectric material in the X-ray diffraction pattern of the first calcined film.

In the second calcining step S06, from the viewpoint of improving the crystallinity of the film, the second calcining temperature is preferably equal to or higher than a temperature of (crystallization initiation temperature +50°C), and more preferably equal to or higher than a temperature of (crystallization initiation temperature +75°C). The heating time varies depending on the thickness, size, and the like of the first calcined film, but is preferably in a range of 30 seconds or more and 5 minutes or less. The heating atmosphere is not particularly limited, but an air atmosphere is preferable. As a heating apparatus, it is possible to use a hot plate or a rapid thermal annealing apparatus (RTA). It is preferable to continuously perform the first calcining step S04 and the second calcining step S06 using a hot plate as the heating apparatus.

### (Main Firing Step S07)

The main firing step S07 is a step of obtaining a PZT-based piezoelectric film by heating the second calcined film obtained in the second calcining step S06 at a main firing temperature which is in a range of equal to or higher than a temperature of (crystallization initiation temperature + 100°C) and equal to or lower than a temperature of (crystallization initiation temperature + 200°C) and which is equal to or higher than a temperature of (second calcining temperature + 25°C). For example, in a case where the crystallization initiation temperature is 550°C, the main firing temperature is a temperature of 650°C or higher and 750°C or lower and is the temperature of (second calcining temperature + 25°C) or higher. In the main firing step S07, since the main firing temperature is in the range described above, the crystallization of the second calcined film proceeds and the entire film is sufficiently crystallized. The second calcined film before the main firing step S07 contains more perovskite crystal phase than the first calcined film and the film itself is shrunk sufficiently. For this reason, when the second calcined film is heated at the main firing temperature, the volume shrinkage due to crystallization is reduced, and the stress in the film which is generated by this crystallization is low in comparison with the stress in the film which is generated in a case where the first calcined film is heated at the main firing temperature. For this reason, for the PZT-based piezoelectric film obtained in the main firing step S07, the generation of peeling and cracking is suppressed.

In the main firing step S07, from the viewpoint of reliably crystallizing the entire film, the main firing temperature is preferably equal to or higher than a temperature of (crystallization initiation temperature +125°C). The heating time varies depending on the thickness, size, and the like of the second calcined film, but is preferably in a range of 30 seconds or more and 5 minutes or less. The heating atmosphere is not particularly limited, but an air atmosphere is preferable. As a heating apparatus, it is possible to use a hot plate or an infrared rapid thermal annealing apparatus (RTA). It is preferable to continuously perform the second calcining step S06 and the main firing step S07 using a hot plate as the heating apparatus.

It is possible to advantageously use the PZT-based piezoelectric film obtained as described above as a material for piezoelectric elements. It is possible to produce a piezoelectric element using the PZT-based piezoelectric film described above, for example, by first forming an upper electrode on the surface of the PZT-based piezoelectric film and then applying an AC voltage between the upper electrode and a lower electrode to polarize the PZT-based piezoelectric film in the film thickness direction.

The PZT-based piezoelectric film obtained by the manufacturing method of the present embodiment has a gentle compositional gradient of Zr/Ti in the film thickness direction and a high composition uniformity. For this reason, the piezoelectric element produced using the piezoelectric film obtained by the manufacturing method of the present embodiment has a high piezoelectric constant d₃₃ in the film thickness direction.

Next, a description will be given of a piezoelectric film and a piezoelectric element according to one embodiment of the present invention with reference to the accompanying drawings.

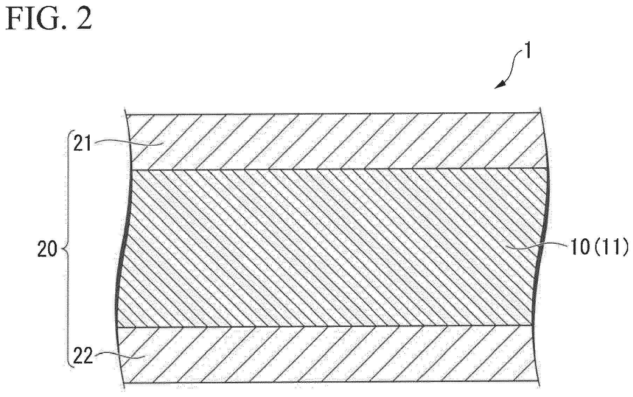

FIG. 2 is a schematic cross-sectional view of a piezoelectric element using a piezoelectric film according to one embodiment of the present invention.

As shown in FIG. 2, the piezoelectric element 1 includes a piezoelectric layer 11 consisting of a piezoelectric film 10, and an electrode layer 20 formed on the surface of the piezoelectric layer 11.

The piezoelectric film 10 has a tetragonal perovskite crystal including at least lead (Pb), zirconium (Zr), and titanium (Ti).

The content ratio of zirconium and titanium in the piezoelectric film 10 is preferably in a range of zirconium:titanium = 54:46 to 40:60 in terms of molar ratio and more preferably in a range of zirconium:titanium = 50:50 to 40:60.

The tetragonal perovskite crystal has a ratio of the length of the c-axis with respect to the length of the a-axis (c-axis/a-axis ratio) in a range of 1.0071 or more and 1.0204 or less.

In a case where the c-axis/a-axis ratio is larger than 1.0204, the anisotropy is excessively large, thus, domain rotation due to an electric field does not easily occur and there is a concern that a high piezoelectric property may not be obtained. On the other hand, in a case where the c-axis/a-axis ratio is smaller than 1.0071, the contribution of the domain rotation to piezoelectric property is reduced and there is a concern that a high piezoelectric property may not be obtained. For this reason, the piezoelectric film 10 of the present embodiment has a c-axis/a-axis ratio in a range of 1.0071 or more and 1.0204 or less. In order to further improve the piezoelectric property, the c-axis/a-axis ratio is more preferably 1.0150 or less, and particularly preferably 1.0100 or less. The c-axis/a-axis ratio is more preferably 1.0080 or more, and particularly preferably 1.0085 or more.

The length of the a-axis of the tetragonal perovskite crystal included in the piezoelectric film 10 is preferably in a range of 4.04 Å or more and 4.08 Å or less. The length of the c-axis is preferably in a range of 4.10 Å or more and 4.15 Å or less.

In the present embodiment, the length of the a-axis and the length of the c-axis of the tetragonal perovskite crystal are values calculated by analyzing an X-ray diffraction pattern of the piezoelectric film, which is measured by the in-plane method using the Cu-Kα line, using whole-powder pattern decomposition (WPPD) method.

The piezoelectric film 10 has a concentration gradient in the thickness direction. The piezoelectric film 10 preferably has a gradient of zirconia concentration and titanium concentration in the thickness direction. For the concentration gradient of titanium and zirconia, the difference between the lowest value and highest value of the molar ratio (Ti/Zr ratio) of titanium concentration to zirconia concentration is preferably in a range of more than 0.1 and 0.45 or less, and more preferably in a range of 0.14 or more and 0.45 or less. In a case where the difference between the lowest value and highest value of the Ti/Zr ratio is excessively small, there is a concern that it may be difficult to improve the voltage endurance property of the piezoelectric film 10. On the other hand, in a case where the difference between the lowest value and highest value of the Ti/Zr ratio is excessively large, there is a concern that the piezoelectric property of the piezoelectric film 10 may decrease. The lowest value of the Ti/Zr ratio is preferably in a range of 0.50 or more and 0.80 or less. In addition, the highest value of the Ti/Zr ratio is preferably in a range of 1.00 or more and 1.25 or less.

In the present embodiment, the concentrations of Ti and Zr in the thickness direction of the piezoelectric film 10 are values measured by cross-sectional observation of the piezoelectric film 10 using a transmission electron microscope (TEM) and elemental mapping using an energy dispersive X-ray spectrometer (EDS). In detail, the concentrations (atom%) of Ti and Zr at a predetermined thickness position are measured in a cross-section along the thickness direction of the piezoelectric film 10. This measurement is performed along the thickness direction of the piezoelectric film 10 (linear analysis in the thickness direction). Then, the Ti/Zr ratio at each thickness position is determined.

In the X-ray diffraction pattern measured using the Cu-Ka line, the piezoelectric film 10 preferably has a half width of the diffraction peak derived from the (400) plane of the tetragonal perovskite crystal, which is 1.40 degrees or less in terms of a diffraction angle of 2θ.The half width indicates the variation in the orientation direction of the tetragonal perovskite crystal. A small half width represents a small variation in the orientation direction of the tetragonal perovskite crystal. In a case where the half width is larger than 1.40 degrees, the variation in the orientation direction of the tetragonal perovskite crystal becomes excessively large and there is a concern that the piezoelectric property may decrease. In order to further improve the piezoelectric property, the half width is particularly preferably in a range of 0.80 degrees or more and 1.40 degrees or less.

The half width is determined from the X-ray diffraction pattern of the piezoelectric film measured using the Cu-Ka line. The method for measuring the X-ray diffraction pattern may be an in-plane method or an out-of-plane method. In the case of PZT-based piezoelectric films, the diffraction peak derived from the (400) plane of the tetragonal perovskite crystal is generally found in a range of 94 degrees or more and 103 degrees or less of a diffraction angle of 2θ.

In the piezoelectric element 1 of the present embodiment, the thickness of the piezoelectric film 10 (piezoelectric layer 11) is not particularly limited and it is possible to adjust the thickness appropriately depending on the use application. The thickness of the piezoelectric film 10 is generally in a range of 0.5 µm or more and 5 µm or less, and preferably in a range of 0.5 µm or more and 3 µm or less. In a case where the thickness of the piezoelectric film 10 is 1 µm or more, an adhesion layer is preferably interposed between a lower electrode 22 and the piezoelectric film 10. That is, in a case where the piezoelectric film 10 with a thickness of 1 µm or more is formed on the lower electrode 22, an adhesion layer is preferably formed on the surface of the lower electrode 22 in advance. For example, it is possible to use lead titanate as a material for the adhesion layer.

The electrode layer 20 formed on the surface of the piezoelectric film 10 includes an upper electrode 21 formed on the upper surface of the piezoelectric film 10 and the lower electrode 22 formed on the lower surface of the piezoelectric film 10. It is possible to use metals such as platinum (Pt), iridium, and the like as materials for the upper electrode 21 and the lower electrode 22. The upper electrode 21 and the lower electrode 22 may be formed of the same material or may be formed of different materials.

According to the method for manufacturing a piezoelectric film of the present embodiment, which is configured as described above, the content ratio of zirconium and titanium in the coating solution is in a range of 54:46 to 40:60 in terms of molar ratio, thus, it is possible to obtain a piezoelectric film having a high piezoelectric property and voltage endurance property. In addition, the first calcining temperature in the first calcining step S04 is relatively low, in a range of the crystallization initiation temperature or higher and a temperature of (crystallization initiation temperature +40°C) or lower, thus, variation does not easily occur in the temperature in the film thickness direction and crystallization proceeds uniformly, therefore, the compositional gradient of Zr/Ti in the film thickness direction becomes gentle. In addition, since the first calcined film obtained in the first calcining step S04 has a partially generated perovskite crystal phase, the compositional gradient of Zr/Ti in the film thickness direction does not easily become larger due to subsequent heating. In addition, by performing the second calcining step S06 after the first calcining step S04 and before the main firing step S07, the amount of change in the film structure due to crystallization of the film by heating in the main firing step S07 is reduced and the stress generated in the film is reduced. For this reason, peeling or cracking is not easily generated in the obtained PZT-based piezoelectric film. Therefore, by using the method for manufacturing a piezoelectric film of the present embodiment, it is possible to manufacture a PZT-based piezoelectric film with a high composition uniformity in the thickness direction with a high yield and without using coating solutions with different compositions.

In addition, in the method for manufacturing a piezoelectric film of the present embodiment, it is possible to easily adjust the film thickness of the obtained PZT-based piezoelectric film by repeatedly performing the coating step S01, the drying step S02, the organic substance removing step S03, and the first calcining step S04, before the second calcining step S06.

Furthermore, in the method for manufacturing a piezoelectric film of the present embodiment, since the organic substance removing step S03 is performed before the first calcining step S04, the generation of peeling or cracking in the first calcined film due to rapid evaporation of the organic substance is suppressed, thus, it is possible to manufacture the PZT-based piezoelectric film more reliably with a high yield.

In addition, according to the piezoelectric film 10 of the present embodiment, the ratio of the length of the c-axis with respect to the length of the a-axis in the tetragonal perovskite crystal is in a range of 1.0071 or more and 1.0204 or less, thus, the piezoelectric property is improved. In addition, when a linear analysis of concentrations of zirconia and titanium in the thickness direction is carried out, the difference between the lowest value and the highest value of the ratio of the concentration of titanium to the concentration of zirconia is more than 0.1 and 0.45 or less and a slight concentration gradient is provided in the thickness direction, thus, the voltage endurance property is improved.

In the piezoelectric film 10 of the present embodiment, in the X-ray diffraction pattern measured using the Cu-Ka line, since the half width of the diffraction peak derived from the (400) plane of the tetragonal perovskite crystal is 1.40 degrees or less in terms of a diffraction angle of 2θ, the variation in the orientation direction of the tetragonal perovskite crystal is reduced and the piezoelectric property of the piezoelectric film is further improved.

In addition, in the piezoelectric film 10 of the present embodiment, the voltage endurance property is further improved by including at least lead, zirconium, and titanium and by having a gradient of zirconia concentration and titanium concentration in the thickness direction.

In the piezoelectric element 1 of the present embodiment, since the piezoelectric layer 11 includes the piezoelectric film 10 described above, the piezoelectric property and the voltage endurance property are improved.

Although embodiments of the present invention were described above, the present invention is not limited thereto and is able to be modified as appropriate in a range not departing from the technical features of the invention.

For example, in the present embodiment, the organic substance removing step S03 is performed, but in a case where the coating solution used in the coating step S01 does not include an organic substance, the organic substance removing step S03 may be omitted.

In addition, in the present embodiment, the first calcined film thickness determination step S05 is performed before the second calcining step S06; however, in a case where it is possible to accurately predict the film thickness of the first calcined film from the coating amount of the coating solution in the coating step S01, the first calcined film thickness determination step S05 may be omitted.

Before the coating step S01, measurement of the crystallization initiation temperature of the coating solution may be performed.

The piezoelectric film obtained by the method for manufacturing a piezoelectric film of the present embodiment is not limited to a film having a tetragonal perovskite crystal in which the ratio of the length of the c-axis with respect to the length of the a-axis is in a range of 1.0071 or more and 1.0204 or less.

### EXAMPLES

Next, a description will be given of the operation and effects of the present invention by Examples.

### <Invention Example 1>

### [Production of Substrate]

As a heat-resistant substrate, a 4-inch silicon substrate was prepared. A thermally oxidized film with a thickness of 500 nm was formed on the surface of the prepared silicon substrate by thermal oxidation. Next, a titanium film with a thickness of 20 nm was formed on the thermally oxidized film by the sputtering method. Then the titanium film was oxidized to form a titanium oxide film by holding and firing at 700°C for 1 minute in an oxygen atmosphere by rapid thermal annealing (RTA). Next, a Pt lower electrode oriented in the (111) direction with a thickness of 100 nm was formed on the surface of the titanium oxide film by the sputtering method. Furthermore, a lanthanum nickelate film with a thickness of 15 nm was formed on the surface of the Pt lower electrode by the sol-gel method. In this manner, a substrate including a silicon oxide film, a titanium oxide film, a Pt lower electrode, and a lanthanum nickelate film laminated in this order from bottom to top on the surface of the silicon substrate was produced.

### [Coating Solution for Forming PZT-based Piezoelectric film]

As a coating solution for forming a PZT-based piezoelectric film, a PZT-N solution (PZT equivalent concentration: 25% by mass, molar ratio of Pb:Zr:Ti = 112:52:48) manufactured by Mitsubishi Materials Corporation was prepared. The crystallization initiation temperature of this coating solution for forming a PZT-based piezoelectric film was 550°C which was measured by the following method.

### (Measurement of Crystallization Initiation Temperature)

A substrate with a coated film was produced by spin-coating for 20 seconds at 3000 rpm while dropping the coating solution for forming a PZT-based piezoelectric film onto the surface of the lanthanum nickelate film of the substrate described above to obtain a coated film. The obtained substrate with a coated film was arranged on a hot plate. Next, the temperature of the hot plate was set to 65°C and the coated film was heated in an air atmosphere for 1 minute to obtain a dried film. Next, the temperature of the hot plate was set to 285°C and the dried film was heated in an air atmosphere for 3 minutes to remove the organic substance included in the dried film. Next, the temperature of the hot plate was set to 450°C and the dried film was fired in an air atmosphere for 1 minute to produce a fired film. By the same operation, fired films, which were fired at different temperatures from 450°C to 600°C in 5°C increments, were produced. For the produced fired films, the X-ray diffraction patterns were measured by a concentration method using the CuKα line and the presence or absence of a peak derived from the (100) plane of the PZT film plane (a diffraction peak derived from the (100) plane of the tetragonal perovskite crystal) at around 22 degrees of a diffraction angle of 2θ was confirmed in the obtained X-ray diffraction pattern. For fired films for which this peak was confirmed, the lowest firing temperature at which the fired film was produced was used as the crystallization initiation temperature.

### [Production of Substrate with PZT-based piezoelectric film]

A substrate with a coated film was produced by spin-coating for 20 seconds at 3000 rpm while dropping the coating solution for forming a PZT-based piezoelectric film onto the surface of the lanthanum nickelate film of the substrate to obtain a coated film (coating step).

The obtained substrate with a coated film was arranged on a hot plate. Next, the temperature of the hot plate was set to 65°C and the coated film was heated in an air atmosphere for 1 minute to obtain a dried film (drying step).

Next, the temperature of the hot plate was set to 285°C and the dried film was heated in an air atmosphere for 3 minutes to remove the organic substance included in the dried film (organic substance removing step).

Next, the temperature of the hot plate was set to 550°C and the dried film was heated in an air atmosphere for 1 minute to obtain the first calcined film (first calcining step).

Next, the coating step, the drying step, the organic substance removing step, and the first calcining step were repeated four times to obtain a first calcined film with a thickness of 0.8 µm to produce a substrate with a first calcined film.

Next, the temperature of the hot plate on which the substrate with the first calcined film was arranged was set to 575°C and the first calcined film was heated in an air atmosphere for 1 minute to obtain a second calcined film (second calcining step).

Next, the temperature of the hot plate was set to 700°C and the second calcined film was heated in an air atmosphere for 1 minute to obtain a PZT-based piezoelectric film (main firing step). In this manner, a substrate with a PZT-based piezoelectric film of Invention Example 1 was produced.

### <Invention Examples 2 to 7>

As shown in Table 1 below, substrates with a PZT-based piezoelectric film were produced in the same manner as in Invention Example 1, except that the first calcining temperature or second calcining temperature was changed.

### <Invention Example 8>

### [Coating Solution for Forming PZT-based Piezoelectric Film]

As a coating solution for forming a PZT-based piezoelectric film, a PZT-N solution (PZT equivalent concentration: 25% by mass, molar ratio of Pb:Zr:Ti = 112:40:60) manufactured by Mitsubishi Materials Corporation was prepared. The crystallization initiation temperature of this coating solution for forming a PZT-based piezoelectric film was 525°C.

### [Production of Substrate with PZT-based Piezoelectric Film]

A PZT-based piezoelectric film was produced in the same manner as in Invention Example 1, except that the coating solution for forming a PZT-based piezoelectric film described above was used and the second calcining temperature was changed as shown in Table 1 below.

### <Comparative Example 1>

The coating step, drying step, and organic substance removing step were repeated four times without performing the first calcining step to obtain a 0.8 µm dried film. In addition, the obtained dried film was heated for 1 minute in an air atmosphere while the temperature of the hot plate was set to 700°C without performing the second calcining step. Except for the above-described conditions, a substrate with a PZT-based piezoelectric film was produced in the same manner as in Invention Example 1.

### <Comparative Example 2>

A substrate with a PZT-based piezoelectric film was produced in the same manner as in Invention Example 1, except that the first calcining temperature and second calcining temperature were changed as shown in Table 1 below.

### <Comparative Example 3>

A substrate with a PZT-based piezoelectric film was produced in the same manner as in Invention Example 1, except that the temperature of the hot plate was set to 700°C and the first calcined film was heated in an air atmosphere for 1 minute without performing the second calcining step.

### <Comparative Examples 4 to 5>

Substrates with a PZT-based piezoelectric film were produced in the same manner as in Invention Example 1, except that the second calcining temperature was changed as shown in Table 1 below.

### <Comparative Example 6>

A substrate with a PZT-based piezoelectric film was produced in the same manner as in Invention Example 1, except that the second calcining temperature and the main firing temperature were changed as shown in Table 1 below.

**Table 1**

| | Coating solution for forming PZT-based piezoelectric film | | | | Manufacturing conditions of PZT-based piezoelectric film | | | | |
|---|---|---|---|---|---|---|---|---|---|
| | Metal composition (molar ratio). | | | Crystallization initiation temperature (°C) | Drying temperature (°C) | Organic substance removing temperature (°C) | First calcining temperature (°C) | Second calcining Main firing temperature (°C) temperature (°C) | |
| | Pb Zr | | Ti | | | | | | |
| Invention example 1 | 112 | 52 | 48 | 550 | 65 | 285 | 550 | 575 | 700 |
| Invention example 2 | 112 | 52 | 48 | 550 | 65 | 285 | 550 | 590 | 700 |
| Invention example 3 | 112 | 52 | 48 | 550 | 65 | 285 | 550 | 600 | 700 |
| Invention example 4 | 112 | 52 | 48 | 550 | 65 | 285 | 550 | 610 | 700 |
| Invention example 5 | 112 | 52 | 48 | 550 | 65 | 285 | 550 | 625 | 700 |
| Invention example 6 | 112 | 52 | 48 | 550 | 65 | 285 | 550 | 650 | 700 |
| Invention example 7 | 112 | 52 | 48 | 550 | 65 | 285 | 575 | 625 | 700 |
| Invention example 8 | 112 | 40 | 60 | 525 | 65 | 285 | 550 | 625 | 700 |

| | Metal composition (molar ratio) | | | Crystallization initiation temperature (°C) | Drying temperature (°C) | Organic substance removing temperature (°C) | First calcining temperature (°C) | Second calcining temperature (°C) | Main firing temperature (°C) |
|---|---|---|---|---|---|---|---|---|---|
| Pb | Zr | Ti | | | | | | | |
| Comparative example 1 | 112 | 52 | 48 | 550 | 65 | 285 | - | - | 700 |
| Comparative example 2 | 112 | 52 | 48 | 550 | 65 | 285 | 600 | 625 | 700 |
| Comparative example 3 | 112 | 52 | 48 | 550 | 65 | 285 | 550 | - | 700 |
| Comparative example 4 | 112 | 52 | 48 | 550 | 65 | 285 | 550 | 570 | 700 |
| Comparative example 5 | 112 | 52 | 48 | 550 | 65 | 285 | 550 | 660 | 700 |
| Comparative example 6 | 112 | 52 | 48 | 550 | 65 | 285 | 550 | 625 | 640 |

### <Evaluation>

For the substrates with a PZT-based piezoelectric film obtained in Invention Examples 1 to 8 and Comparative Examples 1 to 6, the film thickness of the PZT-based piezoelectric film, presence or absence of cracking and peeling, crystal size of the PZT-based piezoelectric film, crystallinity of the PZT-based piezoelectric film (half width of the (400) plane of tetragonal perovskite crystal), and concentration gradient were measured by the methods described below. In addition, an evaluation sample (piezoelectric element) was produced using a substrate with a PZT-based piezoelectric film by the following method and the piezoelectric property (piezoelectric constant d₃₃) and voltage endurance property (dielectric breakdown voltage) of the PZT-based piezoelectric film were measured. The production of the evaluation sample and the measurement of the piezoelectric constant d₃₃ and dielectric breakdown voltage of the PZT-based piezoelectric film were performed using a substrate with a PZT-based piezoelectric film in which no cracking or peeling was generated in the PZT-based piezoelectric film. The results are shown in Table 2 below.

### (1) Film Thickness of PZT-based Piezoelectric Film

The overall film thickness of the PZT-based piezoelectric film was measured by SEM observation.

### (2) Number of Generations of Peeling and Cracking in PZT-based Piezoelectric Film

The number of generations of peeling and cracking in the PZT-based piezoelectric film was evaluated visually. Evaluation was performed on 10 piezoelectric films. Table 2 shows the number of PZT-based piezoelectric films in which peeling and cracking were generated.

### (3) Crystal Size of PZT-based Piezoelectric Film

The X-ray diffraction pattern of the piezoelectric film was measured by the in-plane method using the Cu-Ka line. As the X-ray diffractometer, the model: SmartLab, manufactured by Rigaku Corporation, was used. The obtained X-ray diffraction patterns were analyzed using whole-powder pattern decomposition (WPPD) to determine the size of the tetragonal perovskite crystals (the length of the a-axis and the length of the c-axis).

### (4) Crystallinity of PZT-based Piezoelectric Film (Variation in Orientation Direction)

The X-ray diffraction pattern of the piezoelectric film was measured by the out-of-plane method using the Cu-Ka line. As the X-ray diffractometer, the model: EMPYREAN (optical system: concentration method) manufactured by Spectris, was used. Using the obtained X-ray diffraction pattern, the half width of the diffraction peak derived from the (400) plane of the tetragonal perovskite crystal was determined.

### (5) Concentration Gradient

The PZT-based piezoelectric film was thinned by a focused ion beam (FIB) and the concentrations of zirconium and titanium in the thickness direction were linearly analyzed by TEM-EDS. The Ti/Zr ratio (molar ratio) was calculated from the obtained titanium concentration and zirconium concentration and the difference (difference in Ti/Zr ratio) between the lowest value and highest value of the Ti/Zr ratio was determined. In a case where the difference between the lowest value and highest value of the Ti/Zr ratio was 0.1 or less, it was assumed that there was no concentration gradient.

### (6) Production of Evaluation Samples (Piezoelectric Elements)

A Pt upper electrode (thickness: 150 nm) was formed by the sputtering method on the surface of each of the substrates with a PZT-based piezoelectric film of Invention Examples 1 to 8 and Comparative Examples 1 to 6. Next, the Pt lower electrode was exposed by removing the PZT-based piezoelectric film and the lanthanum nickelate film by wet etching. Next, the evaluation samples of the Invention Examples 1 to 8 and Comparative Examples 1 to 6 were produced respectively by a heat treatment in an oxygen atmosphere for 1 minute using a rapid thermal annealing apparatus (RTA).

### (7) Piezoelectric Property: Piezoelectric Constant d₃₃

The obtained evaluation samples were formed into rectangles with an area of 1 mm². The piezoelectric constant d₃₃ of each of these evaluation samples (PZT-based piezoelectric films) was measured using a DBLI system (manufactured by aixACCT). Using the DBLI system, as the piezoelectric constant d₃₃, the mechanical displacement ratio per electric field in 33 directions was measured when an AC voltage of ±25 V (-25 V to +25 V, frequency: 1 kHz) was applied between the Pt lower electrode and the Pt upper electrode of each of the evaluation samples.

### (8) Voltage Endurance Property

A voltage was applied to the obtained evaluation sample and the voltage when the leakage current density reached 1.0 x 10⁻⁴A/cm² was used as the dielectric breakdown voltage.

**Table 2**

| | Evaluation of PZT-based piezoelectric film | | | | | | | | |
|---|---|---|---|---|---|---|---|---|---|
| | Film thickness (µm) | Number of generations of peeling and cracking (piece/10 pieces) | Length of a-axis (Å) | Length of c-axis (Å) | c-axis/a-axis ratio | Half width of (400) plane (degrees) | Concentration gradient (difference of Ti/Zr ratio) | Piezoelectric constant d₃₃ (pm/V) | Dielectric breakdown voltage (V) |
| Invention example 1 | 0.80 | 0 | 4.0845 | 4.1074 | 1.0056 | 1.426 | 0.13 | 135 | 51 |
| Invention example 2 | 0.82 | 0 | 4.0845 | 4.1074 | 1.0056 | 1.376 | 0.19 | 147 | 47 |
| Invention example 3 | 0.84 | 0 | 4.0845 | 4.1074 | 1.0056 | 1.219 | 0.26 | 165 | 46 |
| Invention example 4 | 0.83 | 0 | 4.0845 | 4.1074 | 1.0056 | 1.269 | 0.28 | 155 | 55 |
| Invention example 5 | 0.80 | 0 | 4.0845 | 4.1074 | 1.0056 | 1.205 | 0.27 | 158 | 54 |
| Invention example 6 | 0.81 | 0 | 4.0845 | 4.1074 | 1.0056 | 1.321 | 0.27 | 149 | 59 |
| Invention example 7 | 0.82 | 0 | 4.0845 | 4.1074 | 1.0056 | 1.335 | 0.32 | 140 | 51 |
| Invention example 8 | 0.82 | 0 | 4.0482 | 4.1261 | 1.0192 | 1.699 | 0.22 | 137 | 44 |

**Table 2 (Continued)**

| | Evaluation of PZT-based piezoelectric film | | | | | | | | |
|---|---|---|---|---|---|---|---|---|---|
| | Film thickness (µm) | Number of generations of peeling and cracking (piece/10 pieces) | Length of a-axis (Å) | Length of c-axis (Å) | c-axis/a-axis ratio | Half width of (400) plane (degrees) | Concentration gradient (difference of Ti/Zr ratio) | Piezoelectric constant d₃₃ (pm/V) | Dielectric breakdown voltage (V) |
| Comparative example 1 | 0.86 | 0 | 4.0845 | 4.1074 | 1.0056 | 2.162 | 0.56 | 122 | 42 |
| Comparative example 2 | 0.81 | 0 | 4.0845 | 4.1074 | 1.0056 | 1.844 | 0.50 | 126 | 56 |
| Comparative example 3 | 0.81 | 8 | 4.0845 | 4.1074 | 1.0056 | 1.352 | 0.54 | - | - |
| Comparative example 4 | 0.82 | 7 | 4.0845 | 4.1074 | 1.0056 | 1.478 | 0.53 | - | - |
| Comparative example 5 | 0.82 | 0 | 4.0845 | 4.1074 | 1.0056 | 2.184 | 0.62 | 115 | 54 |
| Comparative example 6 | 0.82 | 0 | 4.0845 | 4.1074 | 1.0056 | 1.283 | 0.59 | 123 | 55 |

The PZT-based piezoelectric films produced in Invention Examples 1 to 8, in which the first calcining temperature, the second calcining temperature, and the main firing temperature were in the ranges of the present embodiment, had a small half width of the (400) plane and a high piezoelectric constant d₃₃. This is considered to be due to the improved composition uniformity in the thickness direction of the PZT-based piezoelectric film.

In contrast, the PZT-based piezoelectric film produced in Comparative Example 1, in which the first calcining step and second calcining step were not performed, had a large half width of the (400) plane. This is considered to be because the perovskite crystal was formed all at once by firing the dried film at high temperature, such that the composition in the thickness direction was non-uniform. The PZT-based piezoelectric film produced in Comparative Example 2, in which the first calcining temperature was as high as 600°C (crystallization initiation temperature +50°C), had a large half width of the (400) plane. This is considered to be because a large amount of lead titanate, which had a low crystallization temperature, was formed in the first calcining step, such that the composition in the thickness direction was non-uniform. In the PZT-based piezoelectric film produced in Comparative Example 3, in which the second calcining step was not performed, a large amount of peeling and cracking was generated and the yield was decreased. This is considered to be because the amount of change in the film structure due to crystallization of the film became large in the main firing step and the stress generated in the film increased. In the PZT-based piezoelectric film produced in Comparative Example 4, in which the second calcining temperature was as low as 570°C (crystallization initiation temperature +20°C), a large amount of peeling and cracking was generated and the yield was decreased. This is considered to be because the difference between the second calcining temperature and the main firing temperature (700°C) was large, thus, the amount of change in the film structure due to crystallization of the film in the main firing step was large and the stress generated in the film increased. On the other hand, the PZT-based piezoelectric film produced in Comparative Example 5, in which the second calcining temperature was as high as 660°C (crystallization initiation temperature +110°C), had a large half width of the (400) plane. This is considered to be because a large amount of lead titanate, which had a low crystallization temperature, was formed in the second calcining step, such that the composition in the thickness direction was non-uniform. The PZT-based piezoelectric film produced in Comparative Example 6 in which the main firing temperature was as low as 640°C (crystallization initiation temperature +90°C) had a small half width of the (400) plane, but the piezoelectric element produced using this PZT-based piezoelectric film had a low piezoelectric constant d₃₃. This is considered to be because the crystallization of the PZT-based piezoelectric film did not progress due to the low main firing temperature and the crystallization of the entire film was insufficient.

### <Invention Example 9>

### [Production of Substrate]

In the same manner as in Invention Example 1, a substrate with a thermally oxidized film, a titanium oxide film, a Pt lower electrode, and a lanthanum nickelate film laminated in this order from bottom to top on the surface of the silicon substrate was produced.

### [Coating Solution for Forming PZT-based Piezoelectric Film]

The PZT-N solution (PZT equivalent concentration: 25% by mass, molar ratio of Pb:Zr:Ti = 112:40:60, crystallization initiation temperature: 525°C) manufactured by Mitsubishi Materials Corporation, which was used in Invention Example 8, was prepared.

### [Production of Substrate with PZT-based Piezoelectric Film]

A substrate with a coated film was produced by spin-coating for 20 seconds at 3000 rpm while dropping the coating solution for forming a PZT-based piezoelectric film onto the surface of the lanthanum nickelate film of the substrate to obtain a coated film (coating step).

The substrate with a coated film was arranged on a hot plate. Next, the temperature of the hot plate was set to 65°C and the coated film was heated in an air atmosphere for 1 minute to obtain a dried film (drying step).

Next, the temperature of the hot plate was set to 285°C and the dried film was heated in an air atmosphere for 3 minutes to remove the organic substance included in the dried film (organic substance removing step).

Next, the temperature of the hot plate was set to 550°C (crystallization initiation temperature +25°C) and the dried film was heated in an air atmosphere for 1 minute to obtain the first calcined film (first calcining step).

Next, the coating step, the drying step, the organic substance removing step, and the first calcining step were repeated four times to obtain a first calcined film with a thickness of 0.7 µm to produce a substrate with a first calcined film.

Next, the temperature of the hot plate on which the substrate with the first calcined film was arranged was set to 575°C (crystallization initiation temperature +50°C) and the first calcined film was heated in an air atmosphere for 1 minute to obtain the second calcined film (second calcining step).

Next, the temperature of the hot plate was set to 700°C (crystallization initiation temperature +175°C) and the second calcined film was heated in an air atmosphere for 1 minute to obtain a PZT-based piezoelectric film (main firing step). In this manner, the substrate with a PZT-based piezoelectric film of Invention Example 9 was produced.

### <Invention Examples 10 to 14 and Comparative Example 7>

### [Preparation of Coating Solution for Forming PZT-based Piezoelectric Film]

As coating solutions for forming a PZT-based piezoelectric film, PZT-N solutions (PZT equivalent concentration: 25% by mass, manufactured by Mitsubishi Materials Corporation) having the compositions and crystallization initiation temperatures shown in Table 3 below were prepared. The crystallization initiation temperature of each coating solution for forming a PZT-based piezoelectric film is shown in Table 3 below.

### [Production of Substrate with PZT-based Piezoelectric Film]

A PZT-based piezoelectric film was produced in the same manner as in Invention Example 9, except that the coating solution for forming a PZT-based piezoelectric film described above was used and the drying temperature, organic substance removing temperature, first calcining temperature, second calcining temperature, and main firing temperature were set to the temperatures shown in Table 3 below.

### <Comparative Example 8>

A PZT-based piezoelectric film was produced on the surface of the lanthanum nickelate film of the substrate by an RF sputtering method. A PZT film with a thickness of 2.0 µm was formed using a PbZrTiO₃ target (molar ratio of Pb:Zr:Ti = 112:45:55) as a target under conditions where a substrate temperature was 550°C, RF was 300 W, and an Ar gas flow rate was 40 sccm.

### <Evaluation>

For the substrates with a PZT-based piezoelectric film obtained in Invention Examples 9 to 14 and Comparative Examples 7 to 8, the film thickness of the PZT-based piezoelectric film, the presence or absence of cracking and peeling, the crystal size of the PZT-based piezoelectric film, the crystallinity of the PZT-based piezoelectric film (half width of the (400) plane of the tetragonal perovskite crystal), the concentration gradient, the piezoelectric property (piezoelectric constant d₃₃), and the voltage endurance property (dielectric breakdown voltage) were measured.

The results are shown in Table 4 below.

**Table 3**

| | Coating solution for forming PZT-based piezoelectric film | | | | Manufacturing conditions of PZT-based piezoelectric film | | | | |
|---|---|---|---|---|---|---|---|---|---|
| | Metal composition (molar ratio) | | | Crystallization initiation temperature (°C) | Drying temperature (°C) | Organic substance removing temperature (°C) | First calcining temperature (°C) | Second calcining temperature (°C) | Main firing temperature (°C) |
| | Pb | Zr | Ti | | | | | | |
| Invention example 9 | 112 | 40 | 60 | 525 | 65 | 285 | 550 | 575 | 700 |
| Invention example 10 | 112 | 46 | 54 | 530 | 65 | 285 | 555 | 580 | 700 |
| Invention example 11 | 112 | 48 | 52 | 540 | 65 | 285 | 565 | 590 | 700 |
| Invention example 12 | 112 | 50 | 50 | 550 | 65 | 285 | 575 | 600 | 700 |
| Invention example 13 | 112 | 52 | 48 | 550 | 65 | 285 | 575 | 600 | 700 |
| Invention example 1.4 | 112 | 54 | 46 | 550 | 65 | 285 | 575 | 600 | 700 |
| Comparative example 7 | 112 | 58 | 42 | 565 | 65 | 285 | 590 | 615 | 700 |
| Comparative example 8 | Produced by sputtering method | | | | | | | | |

**Table 4**

| | Evaluation of PZT-based piezoelectric film | | | | | | | | |
|---|---|---|---|---|---|---|---|---|---|
| | Film thickness (µm) | Number of generations of peeling and cracking (piece/10 pieces) | Length of a-axis (Å) | Length of c-axis (Å) | c-axis/a-axis ratio | Half width of (400) plane (degrees) | Concentration gradient (difference of Ti/Zr ratio) | Piezoelectric constant d₃₃ (pm/V) | Dielectric breakdown voltage (V) |
| Invention example 9 | 0.7 | 0 | 4.0482 | 4.1261 | 1.0192 | 0.858 | 0.14 | 152 | 50 |
| Invention example 10 | 0.7 | 0 | 4.0606 | 4.1017 | 1.0101 | 1.265 | 0.19 | 156 | 56 |
| Invention example 11 | 0.7 | 0 | 4.0671 | 4.1000 | 1.0081 | 1.380 | 0.31 | 150 | 58 |
| Invention example 12 | 0.7 | 0 | 4.0771 | 4.1059 | 1.0071 | 1.257 | 0.42 | 158 | 54 |
| Invention example 13 | 0.7 | 0 | 4.0845 | 4.1074 | 1.0056 | 1.385 | 0.43 | 140 | 52 |
| Invention example 14 | 0.7 | 0 | 4.0919 | 4.1114 | 1.0048 | 1.301 | 0.35 | 130 | 59 |
| Comparative example 7 | 0.7 | 0 | 4.1040 | 4.1180 | 1.0034 | 1.265 | 0.43 | 115 | 58 |
| Comparative example 8 | 2.0 | 0 | 4.0830 | 4.1571 | 1.0181 | 1.351 | No concentration gradient | 120 | 35 |

The PZT-based piezoelectric films obtained in Invention Examples 9 to 14 using coating solutions for forming a PZT-based piezoelectric film in which the content ratio of Zr and Ti was in a range of 54:46 to 40:60 in terms of molar ratio had a larger piezoelectric constant d₃₃ and an improved piezoelectric property compared to the PZT-based piezoelectric film obtained in Comparative Example 7 using a coating solution for forming a PZT-based piezoelectric film in which the content ratio of Zr and Ti was 58:42 in molar ratio. In particular, it was confirmed that, in the PZT-based piezoelectric films obtained in Invention Examples 9 to 12 using coating solutions for forming a PZT-based piezoelectric film in which the content ratio of Zr and Ti was in a range of 50:50 to 40:60 in molar ratio, the ratio of the length of the c-axis with respect to the length of the a-axis of the tetragonal perovskite crystal (c-axis/a-axis ratio) was in a range of 1.0071 or more and 1.0204 or less, the piezoelectric constant d₃₃ was large, and the piezoelectric property was greatly improved. In addition, it was confirmed that the PZT-based piezoelectric film of Comparative Example 8, which was produced by the sputtering method, had a small dielectric breakdown voltage and low voltage endurance property. This is considered to be because a concentration gradient was not provided in the thickness direction.

### <Invention Example 15>

### [Production of Substrate]

In the same manner as in Invention Example 1, a substrate with a thermally oxidized film, a titanium oxide film, a Pt lower electrode, and a lanthanum nickelate film laminated in this order from bottom to top on the surface of the silicon substrate was produced.

### [Coating Solution for Forming PZT-based Piezoelectric Film]

The PZT-N solution (PZT equivalent concentration: 25% by mass, molar ratio of Pb:Zr:Ti = 112:52:48, crystallization initiation temperature: 550°C) manufactured by Mitsubishi Materials Corporation, which was used in Invention Example 1, was prepared.

### [Production of Substrate with PZT-based Piezoelectric Film]

A PZT-based piezoelectric film was produced in the same manner as in Invention Example 1, except that the coating step, the drying step, the organic substance removing step, and the first calcining step were repeated eight times to obtain a first calcined film with a thickness of 1.6 µm and produce the substrate with a first calcined film.

### <Invention Example 16>

A PZT-based piezoelectric film was produced in the same manner as in Invention Example 15, except that a lead titanate film with a thickness of 4 nm was formed on the lanthanum nickelate film of the substrate by the RF sputtering method.

### <Invention Example 17>

A PZT-based piezoelectric film was produced in the same manner as in Invention Example 15 except that, in the production of a substrate with a PZT-based piezoelectric film, the coating step, the drying step, the organic substance removing step, and the first calcining step were repeated 12 times to obtain a first calcined film with a thickness of 2.4 µm and produce a substrate with a first calcined film.

### <Evaluation>

For the substrates with a PZT-based piezoelectric film obtained in Invention Examples 15 to 17, the film thickness of the PZT-based piezoelectric film, the presence or absence of cracking and peeling, the crystal size of the PZT-based piezoelectric film, the crystallinity of the PZT-based piezoelectric film (half width of the (400) plane of the tetragonal perovskite crystal), the concentration gradient, the piezoelectric property (piezoelectric constant d₃₃), and the voltage endurance property (dielectric breakdown voltage) were measured. The manufacturing conditions of the substrates with a PZT-based piezoelectric film of Invention Examples 15 to 17 are shown in Table 5 below. In addition, the evaluation results are shown in Table 6 below.

**Table 5**

| | Coating solution for forming PZT-based piezoelectric film | | | | Lead titanate layer | Manufacturing conditions of PZT-based piezoelectric film | | | | |
|---|---|---|---|---|---|---|---|---|---|---|
| | Metal composition (molar ratio) | | | Crystallization initiation temperature (°C) | | Drying temperature (°C) | Organic substance removing temperature (°C) | First calcining temperature (°C) | Second calcining temperature (°C) | Main firing temperature (°C) |
| | Pb | Zr | Ti | | | | | | | |
| Invention example 15 | 112 | 52 | 48 | 550 | No | 65 | 285 | 550 | 610 | 700 |
| Invention example 16 | 112 | 52 | 48 | 550 | Yes | 65 | 285 | 550 | 610 | 700 |
| Invention example 17 | 112 | 52 | 48 | 550 | No | 65 | 285 | 550 | 610 | 700 |

**Table 6**

| | Evaluation of PZT-based film | | | | | | | | |
|---|---|---|---|---|---|---|---|---|---|
| | Film thickness (µm) | Number of generations of peeling and cracking (piece/10 pieces) | Length of a-axis (Å) | Length of c-axis (Å) | c-axis/a-axis ratio | I Half width of (400) plane (degrees) | Concentration gradient (difference of Ti/Zr ratio) | Piezoelectric constant d₃₃ (pm/V) | Dielectric breakdown voltage (V) |
| Invention example 15 | 1.60 | 2 | 4.0845 | 4.1074 | 1.0056 | 1.22 | 0.21 | 175 | 67 |
| Invention example 16 | 1.62 | 0 | 4.0845 | 4.1074 | 1.0056 | 1.19 | 0.22 | 179 | 62 |
| Invention example 17 | 2.43 | 2 | 4.0845 | 4.1074 | 1.0056 | 1.21 | 0.27 | 189 | 125 |

It was confirmed that the PZT-based piezoelectric films obtained in Invention Examples 15 to 17 had a larger piezoelectric constant d₃₃ and dielectric breakdown voltage in comparison with the PZT-based piezoelectric film obtained in Invention Example 1 and that the piezoelectric property and voltage endurance property were improved. In addition, in Invention Example 16, in which a lead titanate film was formed on the surface of the lanthanum nickelate film of the substrate, the number of generations of peeling and cracking was zero. This is because the adhesion between the substrate and the PZT-based piezoelectric film was improved by interposing a lead titanate film.

### Industrial Applicability

According to the present embodiment, it is possible to manufacture piezoelectric films with a high composition uniformity in the thickness direction with a high yield and without using coating solutions with different compositions. In addition, it is possible to provide piezoelectric films and piezoelectric elements with a high piezoelectric property and voltage endurance property. Therefore, it is possible to suitably apply the present embodiment to piezoelectric films in piezoelectric elements used in vibration-generating elements, sensors, actuators, ink jet heads, auto-focusing devices, and the like, and to the manufacturing steps thereof.

### Explanation of Reference Signs

- 1:: Piezoelectric element
- 10:: Piezoelectric film
- 11:: Piezoelectric layer
- 20:: Electrode layer
- 21:: Upper electrode
- 22:: Lower electrode

## Claims

1. A method for manufacturing a piezoelectric film, the method comprising:
a coating step of obtaining a coated film by coating a coating solution on a substrate, wherein the coating solution includes at least lead, zirconium, and titanium, a content ratio of the zirconium and the titanium is in a range of 54:46 to 40:60 in terms of molar ratio, and a perovskite crystal phase is generated by heating the coating solution at a temperature equal to or higher than a crystallization initiation temperature;
a drying step of obtaining a dried film by drying the coated film;
a first calcining step of obtaining a first calcined film by heating the dried film at a first calcining temperature in a range of equal to or higher than the crystallization initiation temperature and equal to or lower than a temperature of the crystallization initiation temperature + 40°C;
a second calcining step of obtaining a second calcined film by heating the first calcined film at a second calcining temperature which is equal to or higher than a temperature of the first calcining temperature + 25°C and in a range of equal to or higher than a temperature of the crystallization initiation temperature + 25°C and equal to or lower than a temperature of the crystallization initiation temperature + 100°C; and
a main firing step of obtaining a piezoelectric film by heating the second calcined film at a main firing temperature which is equal to or higher than a temperature of the second calcining temperature + 25°C and in a range of equal to or higher than a temperature of the crystallization initiation temperature + 100°C and equal to or lower than a temperature of the crystallization initiation temperature + 200°C.

2. The method for manufacturing a piezoelectric film according to Claim 1,
wherein the coating step, the drying step, and the first calcining step are repeatedly performed before the second calcining step.

3. The method for manufacturing a piezoelectric film according to Claim 1 or 2,
wherein the coating solution contains an organic substance, and
the method further comprises an organic substance removing step of removing the organic substance included in the dried film by heating the dried film after the drying step and before the first calcining step.

4. The method for manufacturing a piezoelectric film according to any one of Claims 1 to 3,
wherein a content ratio of the zirconium and the titanium in the coating solution is in a range of 50:50 to 40:60 in terms of molar ratio.

5. A piezoelectric film comprising:
a tetragonal perovskite crystal including at least lead, zirconium, and titanium,
wherein the tetragonal perovskite crystal has a ratio of a length of a c-axis to a length of an a-axis in a range of 1.0071 or more and 1.0204 or less, and, when a linear analysis of concentrations of zirconia and titanium in a thickness direction is carried out, a difference between a lowest value and a highest value of a molar ratio of the concentration of titanium to the concentration of zirconia is more than 0.1 and 0.45 or less.

6. The piezoelectric film according to Claim 5,
wherein, in an X-ray diffraction pattern measured using a Cu-Ka line, a half width of a diffraction peak derived from a (400) plane of the tetragonal perovskite crystal is 1.40 degrees or less in terms of a diffraction angle of 2θ.

7. The piezoelectric film according to Claim 5 or 6,
wherein a film thickness is in a range of 0.5 µm or more and 5 µm or less.

8. A piezoelectric element comprising:
a piezoelectric layer; and
an electrode layer formed on a surface of the piezoelectric layer,
wherein the piezoelectric layer includes the piezoelectric film according to any one of Claims 5 to 7.
